Europäisches Patentamt

European Patent Office

Office européen des brevets

(19)

(11) Veröffentlichungsnummer: **0 075 716**
**B1**

## (12) EUROPÄISCHE PATENTSCHRIFT

(45) Veröffentlichungstag der Patentschrift:
26.11.86

(21) Anmeldenummer: **82107497.8**

(22) Anmeldetag: **17.08.82**

(51) Int. Cl.⁴: **G 01 R 31/28**

(54) Verbessertes Gegenfeld-Spektrometer für die Elektronenstrahl-Messtechnik.

(30) Priorität: **30.09.81 DE 3138901**

(43) Veröffentlichungstag der Anmeldung:
**06.04.83 Patentblatt 83/14**

(45) Bekanntmachung des Hinweises auf die Patenterteilung:
**26.11.86 Patentblatt 86/48**

(84) Benannte Vertragsstaaten:
**DE FR GB NL**

(56) Entgegenhaltungen:
**DE-A-2 805 673**
**DE-A-2 902 495**

**J.Phys.E.Sci.Instrum., vol. 13, 1980, S. 67-73**
**Scanning Electron Microscopy/1979/I.SEM Inc.,**
**AMI O'Hare, IJ 60666 USA, S, 285-296**

(73) Patentinhaber: **Siemens Aktiengesellschaft Berlin und München, Wittelsbacherplatz 2, D-8000 München 2 (DE)**

(72) Erfinder: **Plies, Erich, Dr., Deisenhofener Strasse 79 c, D-8000 München 90 (DE)**

## Beschreibung

Die Erfindung betrifft ein elektrostatisches Gegenfeld-Spektrometer nach dem Oberbegriff des Anspruchs 1.

Die Potentialmessung an Meßpunkten auf Probenoberflächen, insbesondere die quantitarive Potentialmessung an Leitbahnen und Knoten von integrierten mikroelektronischen Bauelementen, mit Hilfe der Elektronenstrahl-Meßtechnik erfordert ein Spektrometer für die Sekundärelektronen.

In einem Elektronenstrahl-Meßgerät werden die zu vermessenden Meßpunkte auf einer Probenoberfläche, z.D. Leitlahnen von integrierten mikroelektronischen Baueieneyten, mit Primärelektronen bestrahlt, wobei unter anderem Sekundärelektronen ausgelöst werden. Je nach Potential der vermessenen Leitbahn wird die Energieverteilungsfunktion der Sekundärelektronen verändert. In einem Spektrometer für Sekundärelektronen kann man diese Veränderung der Energieverteilungsfunktion der Sekundärelektronen und damit das Potential des vermessenen Meßpunktes auf der Probenoberfläche ermitteln. Von H.P. Feuerbaum ist aus der Veröffentlichung in Scanning Electron Microscopy /I979/I, SEM Inc., AMF O'Hare, IL 60 666,USA, s. 285-296, ein elektrostatisches Gegenfeld-Spektrometer bekannt, welches jedoch nicht die ganze Raumwinkelverteilung der am Meßpunkt auf der Probenoberfläche ausgelösten Sekundärelektronen transmittieren kann. Dies bedingt einen Meßfehler von 5 - 10%. Dieser Meßfehler rührt hauptsächlich daher, daß ein mit einer bestimmten Energie schräg gegen das ebene Gegenfeld-Netz anlaufendes Elektron das Gegenfeid-Gitter unter Umständen nicht mehr passieren kann, während ein senkrecht zum Gegenfeld-Netz startendes Elektron gleicher Energie dieses Gegenfeld-Netz gerade noch passieren kann.

Eine Spektrometeranordnung zur Analyse der Energieverteilung der durch Feldemission auf einer Oberfläche ausgelösten Elektronen ist aus der Veröffentlichung von C. J. Workowski, J. Phys. E: Sci.Instrum. Vol. 13, (1980) Seite 67-73, bekannt. Der energieanalysierende Teil dieser Anordnung besteht aus einer elektrostatischen Linse zur Fokussierung und Abbremsung der auf hohe kinetische Energien beschleunigten Elektronen und zwei halbkugelförmigen, auf unterschiedlichem Potential liegenden Gitterelektroden. Zum Nachweis der abgebremsten und in einen auf der Strahlachse vor den beiden Gitterelektroden liegenden Punkt fokussierten Elektronen werden diese im elektrischen Feld zwischen den halbkugelförmigen Elektroden beschleunigt und anschließend mit Hilfe einer Ringstruktur auf die erste Dynode eines Fotomultipliers abgebildet. In dieser bekannten Spektrometeranordnung tragen allerdings nur die nahezu in Richtung der Symmetrieachse des Systems, also in einen sehr kleinen Raumwinkelbereich emittierten Elektronen zum Meßsignal bei. Der überwiegende Teil der auf der Oberfläche einer zu untersuchenden Substanz durch Feldemission ausgelösten und in Richtung der elektrostatischen Linse beschleunigten Elektronen wird von der als Lochblende ausgebildeten Anode abgefangen.

Der vorliegenden Erfindung liegt die Aufgabe zugrunde, ein elektrostatisches Gegenfeld-Spektrometer der eingangs genannten Art anzugeben, welches eine größere· Raumwinkelverteilung der am Meßpunkt an der Probenoberfläche ausgelösten Sekundärelektronen transmittieren kann.

Diese Aufgabe wird erfindungsgemäß durch ein elektrostatisches Gegenfeld-Spektrometer der eingangs genannten Art gelöst, welches die kennzeichnenden Merkmale des Anspruchs 1 aufweist.

Ausgestaltungen und Vorteile der Erfindung sind in den Unteransprüchen, der Beschreibung und der Zeichnung dargestellt.

Ausführungsbeispiele der Erfindung sind in der Zeichnung dargestellt und werden im folgenden näher erläutert.

Figur 1 zeigt das bekannte elektrostatische Gegenfeld-Spektrometer nach dem zitierten Stand der Technik.

Figur 2 zeigt eine Ausführungsform eines erfindungsgemäßen elektrostatischen Gegenfeld-Spektrometers.

Figur 3 zeigt eine weitere Ausführungsform eines erfindungsgemäßen elektrostatischen Gegenfeld-Spektrometers.

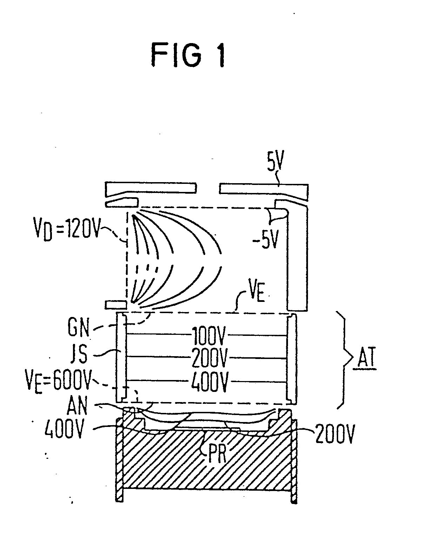

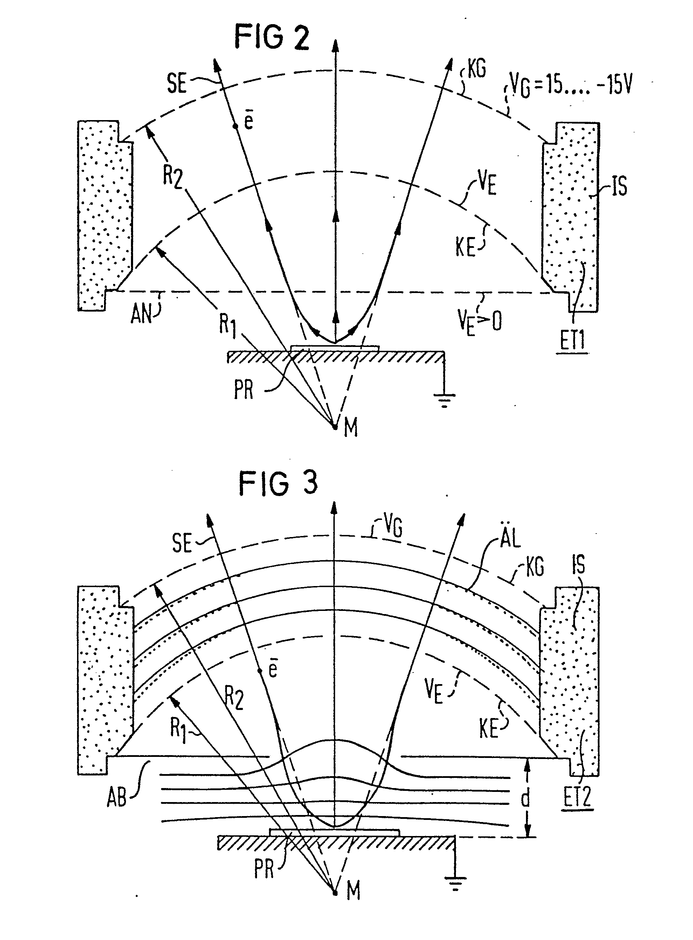

Figur 1 zeigt das bekannte Gegenfeld-Spektrometer nach dem zitierten Stand der Technik von H.P. Feuerbaum. Um zu einer erfindungsgemäßen Ausführungsform zu gelangen, muß das auszutauschende Teil AT durch ein Teil ersetzt werden, welches erfindungsgemäße Merkmale aufweist. Das auszutauschende Teil AT weist ein Absaugnetz AN ein Gegenfeld-Netz GN und einen Isolator IS auf. Das auszutauschende Teil AT befindet sich oberhalb der Probe PR, auf deren Oberfläche Meßpunkte zu vermessen sind. Das auszutauschende Teil AT von Figur 1 wird bei den AusfürüFungsformen nach Figur 2 und nach Figur 3 durch die erfindungsgemäßen Teile ET1 bzw. ET2 ersetzt.

Figur 2 zeigt eine Ausführungsform eines erfindungsgemäßen elektrostatischen Gegenfeld-Spektrometers. Beim erfindungsgemäßen Teil ET1 von Figur 2 wird mit einer Gegenfeld-Elektrodenanordnung, bestehend aus zwei kugelsymmetrischen Elektroden, ein kygelsymmetrisches Gegenfeld aufgebaut. Diese kugelsymmetrischen Elektroden können wie in Fig. 2 angedeutet, etwa als Kugelnetze (KE und KG) ausgebildet sein. Das untere Kugelnetz KE liegt auf demselben Potential $V_E$ wie das Absaugnetz AN. Dadurch entsteht direkt unter den unteren Kugelnetz KE ein feldfreier Raum. Das obere Kugelnetz KG wirkt als Gegenfeld-Gitter und hat ein Potential $D_G$ von etwa 15 bis etwa -15 V. Damit die Bahnen SE der Sekundärelektronen im Gegenfeld wirklich parallel zu den Feldlinien verlaufen, werden die Mittelpunkte beider Kugalnetze KE, KG in den virtuellen Quellpunkt M gelegt. Die Meßpunkte auf der Oberfläche der Probe PR liegen im nichtaktivierten Zustand auf dem Potential Null. Das untere Kugelnetz KE hat den Radius $R_1$, das obere Kugelnetz KG hat den Radius $R_2$.

Figur 3 zeigt eine weitere Ausführungsform eines erfindungsgemäßen elektrostatischen Gegenfeld-Spektrometers. Das erfindungsgemäße Teil ET2 der Ausführungsform nach Figur 3 weist eine Absaugblende AB, ein unteres Kugelnetz KE mit den Radius $R_1$, ein oberes Kugelnetz KG nit dem Radius $R_2$ und einen Isolator IS auf. In der Nähe des Isolators IS sind die in Figur 3 im Schnitt als ansgezogene Linien dargestellten Potentialflächen ÄL zwischen den Kugelnetzen KE, KG nicht nehr streng sphärisch, sondern werden von den eher linearen Potentialabfall auf den Isolator IS in Richtung des oberen Kugelnetzes KG gezogen. Dieser Sachverhalt trifft auch auf das erfindungsgenäße Teil ET1 bei der Ausführungsform nach Figur 2 zu, wo die Potentialflächen in der Nähe des Isolators IS ebenfalls nach oben in Richtung des oberen Kugelnetzes KG gezogen werden. Auch bei den erfindungsgemäßen Teil ET2 bei der Ausführungsforn nach Figur 3 wird ein kugelsymmetrisches Gegenfeld nit Hilfe der beiden Kugelnetze KE, KG erzeugt, wobei das untere Kugelnetz KE auf etwa demselben Potential $V_E$ wie die Absaugblende AB liegt. Für die Potentiale $V_E$ bzw. $V_G$ gilt das bei den erfindungsgenäßen Teil ET1 gesagte. Damit die Bahnen SE der Sekundärelektronen in Gegenfeld wirklich parallel zu den Feldlinien verlaufen, werden die Mittelpunkte beider Kugelnetze KE, KG in den virtuellen Quellpunkt M gelegt. Bei dem erfindungsgenäßen Teil ET2 nach Figur 3 nuß dabei die Linsenwirkung der Absaugblende AB berücksichtigt werden. Wegen des Absaugfeldes ist die als Lochblenden-Linse ausgeführte Absaugblende AB divergent und ihre Brennweite kann näherungsweise über die Davisson-Calbick-Formel zu $f \cong$ -4d angegeben werden, wobei d der Abstand zwischen der Probe PR und der Absaugblende AB ist. Die Erfindung ist selbstverständlich nicht auf die in der Zeichnung dargestellten Ausführungsformen beschränkt. Eine eben geformte Absaugelektrode ist für eine erfindungsgenäße Ausführungsform nicht unbedingt notwendig.

## Patentansprüche

1. Elektrostatisches Gegenfeld-Spektrometer mit einer Absaugelektrode (AN), einer durch einen Abstandshalter (KE, KG), bei dem eine zu untersuchende Probe (PR) unterhalb der Absaugelektrode (AN) angeordnet ist, dadurch gekennzeichnet, daß die Gegenfeld-Elektrodenanordnung zwei kugelsymmetrische Elektroden (KE, KG) aufweist, die ein kugelsymmetrisches Gegenfeld erzeugen, daß die untere der beiden kugelsymmetrischen Elektroden (KE) auf einem ersten Potential ($V_E$) liegt, daß die obere kugelsymmetrische Elektrode (KG) auf einem zweiten Potential ($V_G$) liegt, und daß diese beiden Potentiale ($V_E$, $V_G$) so gewählt sind, daß zwischen den kugelsymmetrischen Elektroden (KE, KG) ein Gegenfeld aufgebaut ist.

2. Elektrostatisches Gegenfeld-Spektrometer nach Anspruch 1, dadurch gekennzeichnet, daß die Mittelpunkte beider kugelsymmetrischen Elektroden (KE, KG) im virtuellen Quellpunkt (M) liegen.

3. Elektrostatisches Gegenfeld-Spektrometer nach Anspruch 1 oder 2, gekennzeichnet durch eine ebene Absaugelektrode.

4. Elektrostatisches Gegenfeld-Spektrometer nach Anspruch 3, gekennzeichnet durch eine Absaugblende (AB) als ebene Absaugelektrode.

5. Elektrostatisches Gegenfeld-Spektrometer nach Anspruch 3, gekennzeichnet durch ein Absaugnetz (AN) als ebene Absaugelektrode.

6. Elektrostatisches Gegenfeld-Spektrometer nach Anspruch 1 bis 5, dadurh gekennzeichnet daß die untere kugelsymmetrische Elektrode (KE) und die Absaugelektrode annähernd auf demselben Potential liegen.

## Claims

1. An electrostatic opposing field spectrometer with a suction electrode (AN), an opposing field electrode arrangement (KE,KG) which is separated from said suction electrode by a spacer (IS), where a sample (PR) which is to be investigated is arranged below the suction electrode (AH), characterised in that the opposing field electrode arrangement comprises two spherical-symmetrical electrodes (KE,KG) which produce a spherical-symmetrical opposing field, that the lower of the two spherical-symmetrical electrodes (KE) carries a first potential ($V_E$), that the upper spherical-symmetrical electrode (KG) carries a second potential ($V_G$) and that these two potentials ($V_E$,$V_G$) are selected to be such that an opponing field builds up between the spherical-symmetrical electrodes (KE,KG).

2. An electrostatic opposing field spectrometer as claimed in claim 1, characterised in that the centre points of the two spherical-symmetrical electrodes (KE,KG) are located at the virtual source point (M).

3. An electrostatic opposing field spectrometer as claimed in claim 1 or 2, characterised by a flat suction electrode.

4. An electrostatic opposing field spectrometer as claimed in claim 3, characterised by a suction diaphragm (AB) as flat suction electrode.

5. An electrostatic opposing field spectrometer as claimed in claim 3, *characterised by* a suction grid (AN) as flat suction electrode.

6. An electrostatic opposing field spectrometer as claimed in claim 1 to 5, *characterised in* that the lower spherical-symmetrical electrode (KE) and suction electrode carry approximately the same potential.

**Revendications**

1. Spectromètre à contre-champ électrostatique, comprenant une électrode d'aspiration (AN), un dispositif d'électrodes de contre-champ (KE, KG) séparé par une entretoise (IS) de l'électrode d'aspiration (AN), avec disposition sous celle-ci d'un échantillon (PR) à examiner, caractérisé en ce que le dispositif d'électrodes de contre-champ présente deux électrodes à symétrie sphérique (KE, KG) qui engendrent un contre-champ à symétrie sphérique, que celle (KE) des deux électrodes à symétrie sphérique située en bas se trouve à un premier potentiel $(V_E)$, que l'électrode (KG) à symétrie sphérique située en haut se trouve à un second potentiel $(V_G)$ et que ces deux potentiels $(V_E, V_G)$ sont choisis de manière qu'un contre-champ soit créé entre les électrodes à symétrie sphérique (KE, KG).

2. Spectromètre selon la revendication 1, caractérise en ce que les centres des deux électrodes à symétrie sphérique (KE, KG) sont situés au point-source virtuel (M).

3. Spectromètre selon la revendication 1 ou 2, caractérisé par une électrode d'aspiration plane.

4. Spectromètre selon la revendication 3, caractérisé par un diaphragme d'aspiration (AB) en tant qu'électrode d'aspiration plane.

5. Spectromètre selon la revendication 3, caractérisé par un réseau d'aspiration (AN) en tant qu'électrode d'aspiration plane.

6. Spectromètre selon les revendications 1 à 5, caractérisé en ce que l'électrode (KE) à symétrie sphérique située en bas et l'électrode d'aspiration se trouvent sensiblement au même potentiel.

# FIG 1

# FIG 2

# FIG 3